# EUROPEAN PATENT SPECIFICATION

(11) **EP 4 579 403 B1**
(45) Date of publication and mention of the grant of the patent: **09.12.2026**
(21) Application number: 23864360.5
(22) Date of filing: 18.05.2023
(51) Int. Cl.: G06F 3/041, H10K 59/40, H10K 59/80, H10K 59/88

(54) **ORGANIC LIGHT-EMITTING DISPLAY PANEL, DISPLAY DEVICE AND DISPLAY PANEL ENCAPSULATION METHOD**
ORGANISCHE LICHTEMITTIERENDE ANZEIGETAFEL, ANZEIGEVORRICHTUNG UND ANZEIGETAFELVERKAPSELUNGSVERFAHREN
ÉCRAN D'AFFICHAGE ÉLECTROLUMINESCENT ORGANIQUE, DISPOSITIF D'AFFICHAGE ET PROCÉDÉ D'ENCAPSULATION D'ÉCRAN D'AFFICHAGE

(30) Priority: 13.09.2022 CN 202211111292
(43) Date of publication of application: 02.07.2025
(73) Proprietor: HKC Corporation Limited, Shenzhen, Guangdong 518000 (CN)
(72) Inventor: GENG, Miao, Shenzhen, Guangdong 518000 (CN); YUAN, Haijiang, Shenzhen, Guangdong 518000 (CN)
(74) Representative: Winter, Brandl - Partnerschaft mbB
(86) International application number: PCT/CN2023/095088
(87) International publication number: WO 2024/055621

(56) References cited:
- CN-A- 101 179 093
- CN-A- 108 281 569
- CN-A- 112 652 727
- CN-A- 113 156 727
- CN-A- 113 589 571
- CN-A- 115 202 514
- US-A1- 2011 229 999

## Description

This application claims the priority and benefit of Chinese patent application number CN202211111292.7, entitled "Organic Light-emitting Display Panel, Display Device, and Method of Packaging Display Panel" and filed September 13, 2022 with China National Intellectual Property Administration.

### TECHNICAL FIELD

The present application relates to the field of display technology, and more particularly to an organic light-emitting display panel, a display device, and a method of packaging a display panel.

### BACKGROUND

The description provided in this section is intended for the mere purpose of providing background information related to the present application but doesn't necessarily constitute prior art. An organic electroluminescent display (Organic Light-Emitting Diode) is a display made of organic electroluminescent light-emitting diodes.

Today, the touch technology of OLED products occupies a large market. In particular, the technology of making the touch sensing circuit on the OLED cover plate is relatively mature. In the current technology where the touch capacitive screen is made on the package, the metal touch lines bonded to the touch region are formed on the cover plate. For hard screens, when the sealing layer is sealed, it will cause uneven laser transmittance and hence uneven sintering, which will lead to problems such as overflow width, air bubbles, and cracks in the sealing layer, which will affect the sealing effect and poor cutting.

At present, by increasing the laser energy or reducing the moving speed of the laser head, laser sintering is performed on the region containing the touch bonding pins to alleviate the problem of uneven sintering. However, if the increased laser energy falls on the reducing the moving speed of the laser head, it cannot be precisely controlled that the energy increase only exists in the touch bonding pin region. Thus, when the laser energy is increased in the normal region, the energy mutation will cause the normal region to form a sudden change in the topography of the sealing layer, which is more likely to cause cracks in the sealing layer, resulting in poor sealing.

CN 112 652 727 A relates to a display panel, a display device and a packaging method. The display panel comprises a first substrate, a second substrate, a display area, a first non-display area and a metal layer, wherein the first substrate and the second substrate are oppositely arranged, and the first non-display area extends in the first direction; the metal layer is located between the first substrate and the second substrate and comprises a first metal layer extending in a first direction; the orthographic projection of the first metal layer on the first substrate is located in the first non-display area; the first metal layer comprises a first area, a second area and a third area; in the second direction, the first area and the third area are located on the two sides of the second area; and the light transmittance of the second area is greater than that of the first area and that of the third area. The laser energy of the first area, the second area and the third area on the first metal layer is relatively uniform, so that the stress caused by non-uniform melting speed of the packaging adhesive is reduced, the packaging effect of the display panel is improved, and the display reliability is ensured.

CN 108 281 569 A relates to an organic light emitting display device and a manufacturing method thereof. The organic light emitting display device comprises a first substrate, a low-temperature polycrystalline silicon layer, an organic electroluminescence device and a second substrate; the low-temperature polycrystalline silicon layer is formed on the first substrate, and the organic electroluminescence device is arranged on the low-temperature polycrystalline silicon layer; the second substrate has a packaging area, a part of the packaging area is provided with a shield layer, and the packaging area is provided with a packaging layer, the shield layer and the packaging layer are overlapped, the packaging layer is arranged on the outer side of the low-temperature polycrystalline silicon layer and the organic electroluminescence device, and the second substrate is connected with the first substrate hermetically through the packaging layer. Since the second substrate is provided with the shield layer, energy from laser to secondary sintering of packaging glass materials is reduced, the packaging layer formed by secondary sintering and other part of packaging layer can be sintered under the same or near laser energy, so that the packaging layer formed by secondary sintering and the other part of packaging layer have the same characteristics, and further, the organic light emitting device has better packaging effect.

### SUMMARY

In view of the above, it is therefore one purpose of the present application to provide an organic light-emitting display panel, a display device, and a method of sealing a display panel, which avoid uneven sealing and improve the sealing effect. The claimed invention is defined by the independent claims. Particular embodiments are described in the dependent claims.

The present application discloses an organic light-emitting display panel, including a cover plate, a substrate and glass glue . The cover plate is arranged opposite to the substrate. The glass glue is disposed at an edge position between the cover plate and the substrate. The organic light-emitting display panel further includes a touch circuit, and the touch circuit is formed on the cover plate. The edge of the cover plate is provided with at least one touch bonding pin. The at least one touch bonding pin is coupled to the touch circuit. A plurality of shielding terminals are disposed on both sides of the at least one touch bonding pin. The at least one touch bonding pin and the shielding terminals are disposed at a position corresponding to the glass glue. The length of each of the plurality of shielding terminals is consistent with the length of the at least one touch bonding pin, and the widths of the plurality of shielding terminals decrease gradually along a direction away from the at least one touch bonding pin.

The present application further discloses a display device, which includes an outer cover plate and an organic light-emitting display panel, where the outer cover plate is arranged on the side of a light-emitting surface of the organic light-emitting display panel.

The present application further discloses a method of sealing a display panel, which is used for sealing an organic light-emitting display panel, the method including the following operations:
coating glass glue at an edge position between the cover plate and the substrate;
performing laser sintering on the glass glue of the display panel along a preset path using laser equipment;
in response to detecting that the laser device has moved to a normal region, sintering the glass glue in the normal region according to a first preset laser energy and a first preset moving speed;
in response to detecting that the laser device has moved to a buffer region, gradually increasing the laser energy and/or gradually reducing the moving speed is to sinter the glass gluein the buffer region; and
in response to detecting that the laser device has moved to the touch bonding pin region, increasing the laser energy to sinter the glass glue in a touch bonding pin region;
wherein the region where the touch bonding pins are disposed is the touch bonding pin region, the region provided with the shielding terminals is the buffer region, and the region without the touch bonding pins and the shielding terminals is the normal region;
wherein touch bonding pins and shielding terminals located on both sides of the touch bonding pins are formed on the cover plate;
wherein the at least one touch bonding pin and the plurality of shielding terminals are disposed at a position corresponding to the sealing layer; wherein a length of each of the plurality of shielding terminals is equal to a length of the at least one touch bonding pin, and wherein widths of the plurality of shielding terminals decrease gradually along a direction of getting farther away from the at least one touch bonding pin; and wherein laser sintering ratios of the normal region, the buffer region and the touch bonding pin region of the laser device are equal.

This application arranges a plurality of shielding terminals on both sides of the touch bonding pin, where the length of the plurality of shielding terminals is consistent with the length of the touch bonding pin, and along the direction of getting away from the touch bonding pin, the widths of the plurality of shielding terminals decrease gradually. In this way, when performing laser irradiation, the energy of the laser head can be controlled to be changed or the speed of the laser head can be changed starting in the region where the shielding terminals are disposed, and the shielding terminals whose widths decrease along the direction of getting away from the touch bonding pin can be used to realize an energy buffering effect in the regions where the shielding terminals are present, so as to avoid a large difference caused by a sudden change in laser energy thus leading to the problem that the junction between the region of non-touch bonding pins and the region of touch bonding pins is prone to uneven sealing caused by a large difference of energy mutation.

### BRIEF DESCRIPTION OF DRAWINGS

FIG. 1 is a block diagram of a display device according to the present application.
FIG. 2 is a schematic diagram of an organic light-emitting display panel according to the present application.
FIG. 3 is a schematic cross-sectional diagram of FIG. 2 along the section line A-A'.
FIG. 4 is a schematic diagram of an arrangement of shielding terminals provided by a first embodiment according to the present application.
FIG. 5 is a schematic cross-sectional diagram of an organic light-emitting display panel provided in a second embodiment according to the present application.
FIG. 6 is a flowchart of a method of sealing a display panel according to the present application.

### DETAILED DESCRIPTION OF EMBODIMENTS

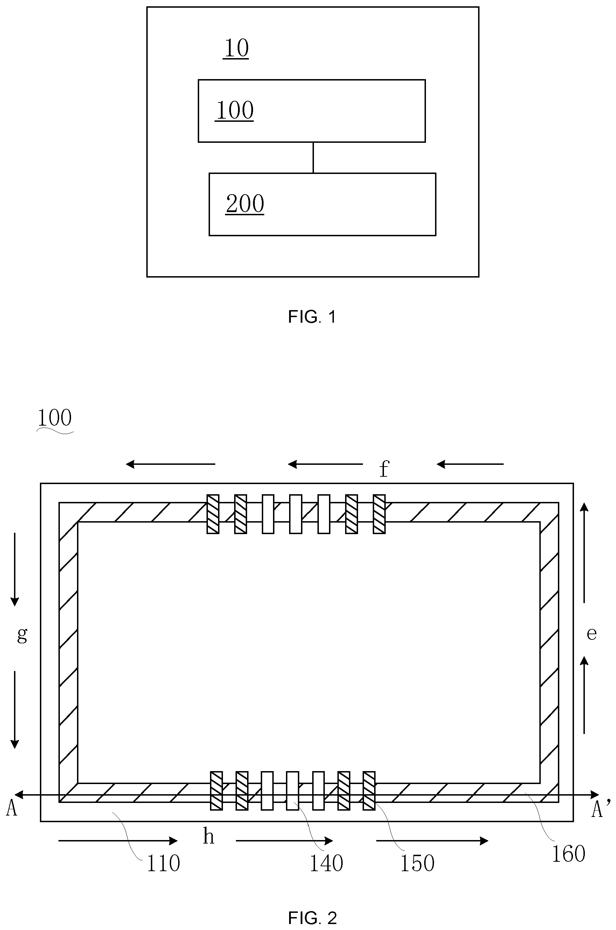

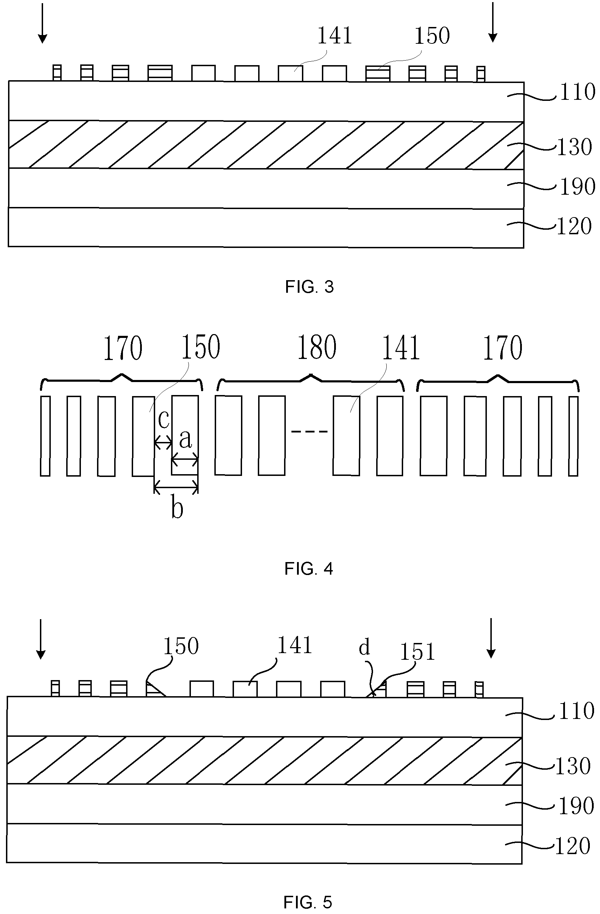

FIG. 1 is a schematic block diagram of a display device according to the present application. FIG. 2 is a schematic diagram of an organic light-emitting display panel according to the present application. FIG. 3 is a schematic cross-sectional diagram of FIG. 1 along the section line A-A'. FIG. 4 is a schematic diagram of an arrangement of touch bonding pins and shielding terminals in this application. As shown in FIG. 1, the present application discloses a display device 10, including an outer cover plate 200 and an organic light-emitting display panel 100. The outer cover plate 200 is disposed on one side of the organic light-emitting display panel 100. In particular, as can be seen from FIGS. 2-3, the organic light-emitting display panel 100 includes a cover plate 110, a substrate 120 and a sealing layer 130. The cover plate 110 is arranged opposite to the substrate 120. The sealing layer 130 is disposed between the cover plate 110 and the substrate 120. The organic light-emitting display panel 100 further includes a touch circuit 140. The touch circuit 140 is formed on the cover plate 110. The edge of the cover plate 110 is provided with at least one touch bonding pin 141. The at least one touch bonding pin 141 is coupled to the touch circuit 140, and the two sides of the at least one touch bonding pin 141 are respectively provided with a plurality of shielding terminals 150. The length of each of the plurality of shielding terminals 150 is consistent with the length of the at least one touch bonding pin 141, and in the direction of getting farther away from the at least one touch bonding pin 141, the widths of the plurality of shielding terminals 150 decrease gradually.

Compared with the solution of laser sintering the region 180 containing the touch bonding pins by increasing the laser energy or reducing the moving speed of the laser head, this application arranges a plurality of shielding terminals 150 on both sides of the at least one touch bonding pin 141, where the length of the plurality of shielding terminals 150 is consistent with the length of the at least one touch bonding pin 141, and along the direction of getting away from the touch bonding pin 141, the widths of the plurality of shielding terminals 150 decrease gradually. In this way, when performing laser irradiation, the energy of the laser head can be slowly increased or the speed of the laser head can be slowly slowed down starting in the region where the shielding terminals 150 are set, and the shielding terminals 150 whose widths decrease along the direction of getting away from the at least one touch bonding pin 141 can be used to realize an energy buffering effect in the regions where the shielding terminals 150 are present, so as to avoid a large difference caused by a sudden change in laser energy thus leading to the problem that the junction between the region of non-touch bonding pins 141 and the region of touch bonding pins 141 is prone to uneven sealing caused by a large difference of energy mutation.

The sealing layer 130 is glass glue. Because the glass glue itself has certain stability and poor fluidity, it is easier to take shape when coating and sealing, and it can also deform after absorbing heat for attaching and adsorption, hence good sealing effect. Of course, other suitable sealing materials can also be used for sealing, as long as the sealing effect and stability can be guaranteed.

Hereinafter this application will be described in further detail with reference to the accompanying drawings and some optional embodiments.

### Embodiment 1:

The direction of the arrow shown in FIG. 2 indicates the direction of a preset path of the laser head. The direction of the arrow shown in FIG. 3 is an irradiation direction of the laser light. As shown in FIGS. 2-3, the region where the touch bonding pins 141 are disposed is the touch bonding pin region 180, the region provided with the shielding terminals 150 is the buffer region 170, and the region without the touch bonding pins 141 and the shielding terminals 150 is the normal region 160. During sealing, the laser light performs sintering and sealing around the edge of the sealing layer 130 along the normal region 160, the buffer region 170 and the touch bonding pin region 180 of the display panel.

As shown in FIG. 2, the organic light-emitting display panel has four sides, respectively e, f, g and h. The lengths of the touch bonding pins and the shielding terminals are measured extending in a direction parallel to e and g are their lengths, and the widths of the touch bonding pins and the shielding terminals extending along the direction f and h, are their widths.

As shown in FIG. 4, the width of the shielding terminal 150 is represented by a. For two adjacent shielding terminals 150, the distance from the side of the first shielding terminal 150 away from the second shielding terminal 150 to the side of the second shielding terminal 150 adjacent to the first shielding terminal 150 is represented by b. The distance between two adjacent shielding terminals 150 is denoted by c.

As shown in FIG. 3, the width of the shielding terminal 150 adjacent to the touch bonding pin 141 is equal to the width of the touch bonding pin 141. The spacing between adjacent touch bonding pins 141 is equal. The spacing between adjacent shielding terminals 150 is equal. The spacing between the touch bonding pin 141 and the shielding terminal 150 that are adjacent to each other is equal. Along the direction of getting away from the touch bonding pin 141, the widths of the plurality of shielding terminals 150 decrease gradually according to a first preset value. In this way, the arrangement intervals of the plurality of touch bonding pins and the plurality of shielding terminals are equal and uniform. The first preset value is 10um. That is, along the direction of getting away from the touch bonding pin 141, under the condition that the distance c between two adjacent shielding terminals 150 remains unchanged, a is gradually decreased by the first preset value at the same time. For example: starting from the shielding terminal 150 closest to the touch bonding pin 141, for adjacent shielding terminals 150, the distance b from the side of the first shielding terminal 150 away from the second shielding terminal 150 to the side of the second shielding terminal 150 adjacent to the first shielding terminal 150 is 250um, the width a of the first shielding terminal 150 is 130um, the distance c between the first shielding terminal 150 and the second shielding terminal 150 is 120um, then in this case a is reduced according to the first preset value of 10um. That is, the width a of the second shielding terminal 150 is 130um-10um=120um. The width a of the third shielding terminal 150 is 120um-10um=110um, then b is the sum of the width of the second shielding terminal 150 plus the distance between the second shielding terminal 150 and the third shielding terminal 150, namely 120um+120um=240um. That is, the distance b from the second shielding terminal 150 to the third shielding terminal 150 is 250um-10um=240um. By analogy, for adjacent shielding terminals 150, b and a are simultaneously arranged in such a way as to descrease by the first preset value. In this case, along the direction of getting away from the touch bonding pin 141, the arrangement between every two adjacent shielding terminals 150 is uniform in proportion.

When the laser light of the laser head performs laser sealing on the region of the sealing layer 130 along the preset path, when it reaches the buffer region 170, the widths of two adjacent shielding terminals 150 increase gradually along the direction adjacent to the touch bonding pin 141. When controlling the laser head to increase energy slowly, since energy is equal to power multiplied by time, if the moving speed of the laser head remains unchanged in this case (that is, the time remains unchanged), then along the preset path, when the power of the laser head increases slowly, the energy of the laser head reaching the touch pin region increases gradually. When reaching the touch bonding pin region 180, the laser light of the laser head is at its maximum. However, since the process of increasing the laser energy of the laser head is a process of gradual and slow increase, and due to the existence of evenly arranged shielding terminals 150, the energy of laser light irradiating each region with a shielding terminal 150 is almost the same during the movement of the laser head. That is, the heat absorbed by the glass glue from laser light is the same. Therefore, in the sealing process, the region of the non-touch bonding pins will not have a large energy difference due to the sudden change of laser light energy, which may otherwise cause uneven sealing. Furthermore, when the laser light reaches the region of the touch bonding pin 141, the energy is also increased as preset to reach the energy value capable of firmly sealing the touch bonding pin region 180. Therefore, the entire sealing process can be made uniform and stable, and the problem of uneven sealing can be avoided.

On the contrary, when the laser light moves from the touch bonding pin region 180 to the normal region 160, the laser light energy of the laser head is gradually reduced. In this case, by slowly reducing the energy in the buffer region 170, it is possible to avoid changes and cracks etc. in the topography of the sealing layer 130 caused by sudden changes in energy, and the sealing ratio of each region in the entire sealing process is made the same as much as possible, so as to improve the overall sealing effect and achieve a high sealing strength.

Similarly, when the moving speed of the laser head is reduced, the energy accumulation can also be increased due to the longer moving time, and a uniform sealing effect can also be achieved. In addition, while the laser light energy of the laser head is changing, it is also possible to reduce the moving speed of the laser head in combination, where the specific setting and cooperation can be carried out according to the situation, and details are not to be described here.

In addition, in this embodiment, along the direction of getting away from the touch bonding pin 141, while the widths of the plurality of shielding terminals 150 are decreased by the first preset value, the distances between two adjacent shielding terminals 150 can also be decreased by a second preset value at the same time, where the first preset value may be equal to the second preset value. That is, the plurality of the shielding terminals 150 are arranged in such a manner that the widths of the shielding terminals 150 and the distance sbetween two adjacent shielding terminals 150 are arranged in descending order by decrements of the same preset value. In this case, a is reduced by the first preset value of 10um, that is, the width a of the second shielding terminal 150 is 130um-10um=120um, and the width a of the third shielding terminal 150 is 120um-10um=110um. The distance c between the second shielding terminal 150 and the third shielding terminal 150 is reduced by the second preset value of 10um, which is 120um-10um=110um. Then in this case b is the sum of the width of the second shielding terminal 150 plus the distance between the second shielding terminal 150 and the third shielding terminal 150, namely 120um+110um=230um. That is, b is 250um-20um=230um. By analogy, by arranging the plurality of shielding terminals 150 in such a descending manner, since the decreasing value of b is slightly larger, in this case, the shielding terminals 150 are relatively densely arranged. Thus, one or two more shielding terminals 150 can be arranged in the buffer region 170, and the descending arrangement of the shielding terminals 150 is also relatively uniform, which can also achieve a more uniform sealing effect during laser irradiation.

Of course, along the direction of getting away from the touch bonding pin 141, it is also possible that the widths of the plurality of shielding terminals 150 decrease gradually by decrements of the first preset value, and the distances between two adjacent shielding terminals 150 increase by a second preset value, where the first preset value is equal to the second preset value, so that the plurality of shielding terminals 150 can also be arranged in descending widths. Then, in this case, the spacing between every two shielding terminals 150 is relatively wide, that is, the plurality of shielding terminals 150 are arranged sparsely. When the laser is irradiated, the energy of the laser light passing through every two shielding terminals 150 and irradiating the sealing layer 130 is more, and so the sealing layer 130 absorbs the energy and has a relatively better sealing effect with the cover plate 110 and the substrate 120. However, since the shielding terminals 150 are still arranged in descending order along the direction of getting away from the touch bonding pin 141, by the cooperation with the laser head, the energy or moving speed of the laser head can still be controlled to make the sealing uniformity better.

The material of the shielding terminal 150 is the same as that of the touch bonding pin 141, and the thickness of the shielding terminal 150 is equal to the thickness of the touch bonding pin 141. The same material can be processed by the same manufacturing procedure, thus saving materials and reducing process. The same thickness is adopted, so that when the laser is illuminated, the transmittance of the laser light through the shielding terminal 150 is consistent with that through the touch bonding pin 141, thus avoiding the problem of uneven sealing of the sealing layer 130 caused by uneven transmittance resulting in different light heat absorbed by the sealing layer 130.

In this embodiment, the shielding terminal 150 may be a metal material. Since the touch bonding pin 141 may be made of metal material, the uniformity of light blocking can be achieved. Furthermore, it is relatively easy to control if the energy is increased during laser irradiation, and the energy can be increased in the same proportion. Of course, the shielding terminal 150 can also be made of a black matrix or a transparent electrode or a color filter material, then the material of the shielding terminal 150 is different from that of the touch bonding pin 141. This is beneficial for the device to detect and identify the touch bonding pin region 180, the buffer region 170 and the normal region 160, thus better controlling the moving speed or energy of the laser head, make the sealing better.

As shown in FIG. 3, the organic light-emitting display panel 100 further includes an inorganic layer 190 disposed between the sealing layer 130 and the substrate 120. It is also possible to coat the sealing layer 130 after the inorganic layer 190 is first formed on the substrate 120.

### Embodiment 2

FIG. 4 is a schematic diagram of an arrangement of shielding terminals provided by a second embodiment according to the present application. As shown in FIG. 4, the difference between this embodiment and the first embodiment is that the shielding terminal 150 closest to the touch bonding pin 141 has a slope 151 on a side adjacent to the touch bonding pin 141, that is, the shielding terminal 150 has a triangular structure. When the shielding terminal 150 is made of a metal material, the metal material itself has the function of blocking light namely it also has the function of reflecting light to a certain extent. By designing the side adjacent to the touch bonding pin 141 as a slope 151, part of the laser light can be properly reflected, and part of the laser light can be reflected from the slope 151 to the sealing layer 130 corresponding to the touch bonding pin region 180, so that the heat of laser light absorbed by the sealing layer 130 at this position can be increased, thereby increasing the sealing adhesive force of the sealing layer 130 at this position, achieving an ideal uniform sealing effect.

The included angle between the slope 151 and the side of the cover plate is d. The slope of the slope 151 is greater than or equal to 45° and less than 90°, that is, 45°≤d<90°. When the slope of the slope 151 is larger, the laser light can be reflected to the touch bonding pin region 180 relatively more. Furthermore, in this case, due to the existence of the slope 151, the laser light can be reflected to the touch bonding pin 141 and then reflected and refracted into the region corresponding to the touch bonding pin 141.

In order to reflect more laser light energy, a reflective material may also be disposed on the slope 151, so that more laser light energy can be reflected to the sealing layer 130 corresponding to the touch bonding pin region 180 in combination with the slope of the slope 151, so that the sealing layer 130 in this region can absorb more laser light energy, thereby improving the sealing adhesion of the sealing layer 130 in this region.

When the shielding terminal 150 is made of a black matrix or a transparent electrode or a color filter material, the light transmittance of the slope 151 can be gradually decreased along the inclined direction of the slope 151. That is, the closer to the cover plate 110, the lower the light transmittance of the shielding terminal 150 having the slope 151. In this way, the light transmittance is designed differently, and the energy absorption at this position can also be made uniformly when the laser is illuminated, so that the energy mutation at this position is also a process of gradual increase or decrease, so that it is not easy to cause the sudden change in energy at this position to be too large thus resulting in a significant sudden change in the topography of the sealing layer 130 and affecting the sealing effect. Of course, when the shielding terminal 150 uses a semi-transparent material, the thickness of the shielding terminal 150 can be set to be thicker than the thickness of the touch bonding pin 141, so as to enhance the light-shielding ability of the shielding terminals 150, making the laser light energy absorbed by the buffer region 170 consistent with that absorbed by the touch bonding pin region 180 and the normal region 160 as much as possible, so as to avoid the sudden change in the topography of the sealing layer 130.

In addition, in this embodiment, the shielding terminal 150 closest to the touch bonding pin 141 can also be other structures with a slope 151. For example: the slope 151 can be arc-shaped, and the arc-shaped arc surface faces the touch bonding pin 141, which is beneficial to the reflection of laser light. Alternatively, the shielding terminal 150 can also be a rectangular structure with a slope 151, which can be set according to the actual situation, and at the same time cooperate with the energy or moving speed of the laser light of the laser head to achieve better sealing uniformity.

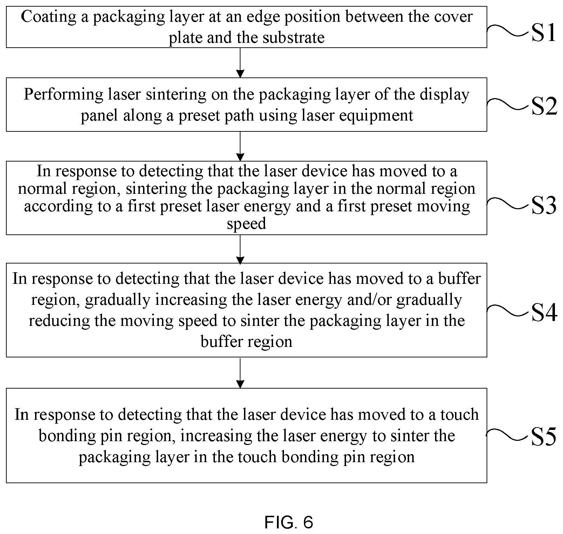

FIG. 6 is a flow chart of a method of sealing a display panel according to the present application. As shown in FIG. 6, the present application further discloses a method of sealing a display panel, which is used for sealing the above-mentioned organic light-emitting display panel, the method including the following operations:
S1: between the cover plate and the substrate, coating the sealing layer at the corresponding edge position;
S2: laser sintering the sealing layer of the display panel along a preset pathby using laser equipment;
S3: when it is detected that the laser device moves to the normal region, sintering the sealing layer in the normal region according to a first preset laser energy and a first preset moving speed;
S4: when it is detected that the laser equipment moves to the buffer region, gradually increasing the laser energy and/or gradually reducing the moving speed to sinter the sealing layer in the buffer region;
S5: when it is detected that the laser device moves to the touch bonding pin region, increasing the laser energy to sinter the sealing layer in the touch bonding pin region;
where touch bonding pins and shielding terminals located on both sides of the touch bonding pins are formed on the cover plate; the laser sintering ratio of the laser device in the normal region, the buffer region and the touch bonding pin region is the same, so that the sealing region of the display panel is evenly sealed after sealing.

In addition, in step 5, the moving speed of the laser head can also be reduced in cooperation with the light-shielding terminals to make the sealing effect better and the uniformity better. Of course, the laser energy change and the moving speed change of the laser head can also be carried out simultaneously.

## Claims

1. An organic light-emitting display panel (100), comprising:
a cover plate (110);
a substrate (120), arranged opposite to the cover plate (110);
glass glue (130) arranged at an edge position between the cover plate (110) and the substrate (120);
a touch circuit (140) formed on the cover plate (110);
at least one touch bonding pin (141), disposed at an edge of the cover plate (110) and coupled to the touch circuit (140); and
a plurality of shielding terminals (150), disposed on both sides of the at least one touch bonding pin (141); wherein the at least one touch bonding pin (141) and the plurality of shielding terminals (150) are disposed at a position corresponding to the glass glue(130);
wherein a length of each of the plurality of shielding terminals (150) is equal to a length of the at least one touch bonding pin (141), and wherein widths of the plurality of shielding terminals (150) decrease gradually along a direction of getting farther away from the at least one touch bonding pin (141).

2. The organic light-emitting display panel (100) as recited in claim 1, wherein a width of each shielding terminal (150) adjacent to the at least one touch bonding pin (141) is equal to a width of the at least one touch bonding pin (141);
wherein a spacing between every two adjacent touch bonding pins (141) is equal, a spacing between every two adjacent shielding terminals (150) is equal, and a spacing between every two touch bonding pins (141) and shielding terminals (150) that are adjacent to each other is equal, and wherein the widths of the plurality of shielding terminals (150) decrease by decrements of a first preset value along the direction of getting farther away from the at least one touch bonding pin (141).

3. The organic light-emitting display panel (100) as recited in claim 1, wherein a width of each shielding terminal (150) adjacent to the at least one touch bonding pin (141) is equal to a width of the at least one touch bonding pin (141); wherein in the direction of getting farther away from the at least one touch bonding pin (141), the widths of the plurality of shielding terminals (150) decrease by decrements of a first preset value, and distances between every two adjacent shielding terminals (150) decrease by decrements of a second preset value, wherein the first preset value is equal to the second preset value.

4. The organic light-emitting display panel (100) as recited in claim 1, wherein a width of each shielding terminal (150) adjacent to the at least one touch bonding pin (141) is equal to a width of the at least one touch bonding pin (141);
wherein along the direction of getting away from the at least one touch bonding pin (141), the widths of the plurality of shielding terminals (150) decrease by decrements of a first preset value, and distances between every two adjacent shielding terminals (150) increase by increments of a second preset value, wherein the first preset value is equal to the second preset value.

5. The organic light-emitting display panel (100) as recited in any one of claims 3 to 4, wherein the first preset value and the second preset value are each 10um.

6. The organic light-emitting display panel (100) as recited in claim 1, wherein a material of each of the plurality of shielding terminals (150) is the same as that of the at least one touch bonding pin (141), and wherein a thickness of each of the plurality of shielding terminals (150) is equal to a thickness of the at least one touch bonding pin (141).

7. The organic light-emitting display panel (100) as recited in claim 6, wherein of each shielding terminal (150) adjacent to the at least one touch bonding pin (141), a side adjacent to the respective touch bonding pin (141) is a slope (151), which is greater than or equal to 45° and less than 90°;
wherein the shielding terminal (150) is made of a metal material.

8. The organic light-emitting display panel (100) as recited in claim 1, wherein, of each shielding terminal (150) adjacent to the at least one touch bonding pin (141), a side adjacent to the respective touch bonding pin (141) is a slope (151), which is greater than or equal to 45° and less than 90°, wherein the plurality of shielding terminals (150) is each made of a color filter material, and wherein in each shielding terminal (150) adjacent to the at least one touch bonding pin (141), a light transmittance gradually decreases along an inclination direction of the slope (151).

9. The organic light-emitting display panel (100) as recited in claim 7, wherein a reflective material is disposed on the slope (151).

10. The organic light-emitting display panel (100) as recited in claim 1, wherein a thickness of each of the plurality of shielding terminals (150) is greater than a thickness of the at least one touch bonding pin (141).

11. The organic light-emitting display panel (100) as recited in claim 7, wherein the slope (151) is arc-shaped, and wherein the arc-shaped arc surface faces the touch bonding pin (141).

12. The organic light-emitting display panel (100) as recited in claim 7, wherein the plurality of shielding terminals (150) is each a rectangular structure having a slope (151).

13. The organic light-emitting display panel (100) as recited in claim 1, wherein a material of each of the plurality of shielding terminals (150) is different than that of the at least one touch bonding pin (141), wherein each of the plurality of shielding terminals (150) is made of a black matrix material.

14. The organic light-emitting display panel (100) as recited in claim 1, further comprising an inorganic layer (190) disposed between the glass glue (130) and the substrate (120).

15. The organic light-emitting display panel (100) as recited in claim 1,
wherein a width of each shielding terminal (150) adjacent to the at least one touch bonding pin (141) is equal to a width of the at least one touch bonding pin (141); wherein a spacing between every two adjacent touch bonding pins (141) is equal, a spacing between every two adjacent shielding terminals (150) is equal, and a spacing between every two touch bonding pin (141) and shielding terminal (150) that are adjacent to each other is equal, and wherein the widths of the plurality of shielding terminals (150) decrease by decrements of a first preset value along the direction of getting farther away from the at least one touch bonding pin (141) and distances between every two adjacent shielding terminals (150) decrease by decrements of a second preset value;
wherein the first preset value and the second preset value are each 10um;
wherein a material of each of the plurality of shielding terminals (150) is identical with that of the at least one touch bonding pin (141), and wherein a thickness of each of the plurality of shielding terminals (150) is equal to a thickness of the at least one touch bonding pin (141).

16. A display device (10), comprising an outer cover plate (200) and an organic light-emitting display panel (100) as recited in claim 1, wherein the outer cover plate (200) is arranged on a side of a light-emitting surface of the organic light-emitting display panel (100).

17. A method of sealing a display panel, used for sealing an organic light-emitting display panel (100), the method comprising:
coating glass glue (130) at the edge position between the cover plate (110) and the substrate (120);
performing laser sintering on the glass glue (130) of the display panel along a preset path using laser equipment;
in response to detecting that the laser device has moved to a normal region (160), sintering the glass glue (130) in the normal region (160) according to a first preset laser energy and a first preset moving speed;
in response to detecting that the laser device has moved to a buffer region (170), gradually increasing the laser energy and/or gradually reducing the moving speed to sinter the glass glue (130) in the buffer region (170); and
in response to detecting that the laser device has moved to a touch bonding pin region (180), increasing the laser energy to sinter the glass glue (130) in the touch bonding pin region (180);
wherein the region where the touch bonding pins (141) are disposed is the touch bonding pin region (180),
the region provided with the shielding terminals (150) is the buffer region (170), and
the region without the touch bonding pins (141) and the shielding terminals (150) is the normal region (160);
wherein the at least one touch bonding pin (141) and the plurality of shielding terminals (150) located on both sides of the at least one touch bonding pin (141) are formed on the cover plate (110);
wherein the at least one touch bonding pin (141) and the plurality of shielding terminals (150) are disposed at a position corresponding to the glass glue (130); wherein a length of each of the plurality of shielding terminals (150) is equal to a length of the at least one touch bonding pin (141), and wherein widths of the plurality of shielding terminals (150) decrease gradually along a direction of getting farther away from the at least one touch bonding pin (141); and
wherein laser sintering ratios of the normal region (160), the buffer region (170) and the touch bonding pin region (180) of the laser equipment are equal.

## Patentansprüche

1. Organische lichtemittierende Anzeigetafel (100), mit:
einer Abdeckplatte (110),
einem Substrat (120), das der Abdeckplatte (110) gegenüberliegend angeordnet ist;
einem Glaskleber (130), die an einer Randposition zwischen der Abdeckplatte (110) und dem Substrat (120) angeordnet ist;
einer Berührungsschaltung (140), die auf der Abdeckplatte (110) ausgebildet ist;
mindestens einem Berührungsverbindungsstift (141), der an einem Rand der Abdeckplatte (110) angeordnet und mit der Berührungsschaltung (140) gekoppelt ist; und
einer Mehrzahl von Abschirmanschlüssen (150), die beidseitig des mindestens einen Berührungsverbindungsstiftes (141) angeordnet sind; wobei der mindestens eine Berührungsverbindungsstift (141) und die Mehrzahl von Abschirmanschlüssen (150) an einer Position angeordnet sind, die dem Glaskleber (130) entspricht;
wobei eine Länge jedes der Mehrzahl von Abschirmanschlüssen (150) gleich einer Länge des mindestens einen Berührungsverbindungsstiftes (141) ist und wobei sich die Breiten der Mehrzahl von Abschirmanschlüssen (150) entlang einer Richtung, die sich vom mindestens einen Berührungsverbindungsstift (141) entfernt, allmählich verringern.

2. Organische lichtemittierende Anzeigetafel (100) nach Anspruch 1,
wobei eine Breite jedes Abschirmanschlusses (150) benachbart zum mindestens einen Berührungsverbindungsstift (141) gleich einer Breite des mindestens einen Berührungsverbindungsstiftes (141) ist;
wobei ein Abstand zwischen je zwei benachbarten Berührungsverbindungsstifte (141) gleich ist, ein Abstand zwischen je zwei benachbarten Abschirmanschlüssen (150) gleich ist und ein Abstand zwischen jeweils einem Berührungsverbindungsstift (141) und einem dazu benachbarten Abschirmanschluss (150) gleich ist, und
wobei sich die Breiten der Mehrzahl von Abschirmanschlüssen (150) entlang der Richtung, die sich vom mindestens einen Berührungsverbindungsstift (141) entfernt, um jeweils einen ersten voreingestellten Wert verringern.

3. Organische lichtemittierende Anzeigetafel (100) nach Anspruch 1,
wobei eine Breite jedes Abschirmanschlusses (150) benachbart zum mindestens einen Berührungsverbindungsstift (141) gleich einer Breite des mindestens einen Berührungsverbindungsstiftes (141) ist;
wobei sich in der Richtung, die sich vom mindestens einen Berührungsverbindungsstift (141) entfernt, die Breiten der Mehrzahl von Abschirmanschlüssen (150) um jeweils einen ersten voreingestellten Wert verringern und sich die Abstände zwischen je zwei benachbarten Abschirmanschlüssen (150) um jeweils einen zweiten voreingestellten Wert verringern, wobei der erste voreingestellte Wert gleich dem zweiten voreingestellten Wert ist.

4. Organische lichtemittierende Anzeigetafel (100) nach Anspruch 1,
wobei eine Breite jedes Abschirmanschlusses (150) benachbart zum mindestens einen Berührungsverbindungsstift (141) gleich einer Breite des mindestens einen Berührungsverbindungsstiftes (141) ist;
wobei sich entlang der Richtung, die sich vom mindestens einen Berührungsverbindungsstift (141) entfernt, die Breiten der Mehrzahl von Abschirmanschlüssen (150) um jeweils einen ersten voreingestellten Wert verringern und sich die Abstände zwischen je zwei benachbarten Abschirmanschlüssen (150) um jeweils einen zweiten voreingestellten Wert vergrößern, wobei der erste voreingestellte Wert gleich dem zweiten voreingestellten Wert ist.

5. Organische lichtemittierende Anzeigetafel (100) nach einem der Ansprüche 3 bis 4, wobei der erste voreingestellte Wert und der zweite voreingestellte Wert jeweils 10 µm betragen.

6. Organische lichtemittierende Anzeigetafel (100) nach Anspruch 1,
wobei ein Material jedes der Mehrzahl von Abschirmanschlüssen (150) dasselbe ist wie das des mindestens einen Berührungsverbindungsstiftes (141), und
wobei eine Dicke jedes der Mehrzahl von Abschirmanschlüssen (150) gleich einer Dicke des mindestens einen Berührungsverbindungsstiftes (141) ist.

7. Organische lichtemittierende Anzeigetafel (100) nach Anspruch 6,
wobei bei jedem Abschirmanschluss (150), der zu mindestens einem Berührungsverbindungsstift (141) benachbart ist, eine dem entsprechenden Berührungsverbindungsstift (141) benachbarte Seite eine Schräge (151) ist, die größer oder gleich 45° und kleiner als 90° ist;
wobei der Abschirmanschluss (150) aus einem Metallmaterial hergestellt ist.

8. Organische lichtemittierende Anzeigetafel (100) nach Anspruch 1,
wobei bei jedem Abschirmanschluss (150), der zum mindestens einen Berührungsverbindungsstift (141) benachbart ist, eine dem entsprechenden Berührungsverbindungsstift (141) benachbarte Seite eine Schräge (151) ist, die größer oder gleich 45° und kleiner als 90° ist,
wobei die Mehrzahl von Abschirmanschlüssen (150) jeweils aus einem Farbfiltermaterial hergestellt ist, und
wobei bei jedem Abschirmanschluss (150), der zu mindestens einem Berührungsverbindungsstift (141) benachbart ist, die Lichtdurchlässigkeit entlang der Neigungsrichtung der Schräge (151) allmählich abnimmt.

9. Organische lichtemittierende Anzeigetafel (100) nach Anspruch 7, wobei auf der Schräge (151) ein reflektierendes Material angeordnet ist.

10. Organische lichtemittierende Anzeigetafel (100) nach Anspruch 1, wobei eine Dicke jedes der Mehrzahl von Abschirmanschlüssen (150) größer ist als eine Dicke des mindestens einen Berührungsverbindungsstiftes (141).

11. Organische lichtemittierende Anzeigetafel (100) nach Anspruch 7, wobei die Schräge (151) bogenförmig ist und wobei die bogenförmige Fläche dem Berührungsverbindungsstift (141) zugewandt ist.

12. Organische lichtemittierende Anzeigetafel (100) nach Anspruch 7, wobei die Mehrzahl von Abschirmanschlüssen (150) jeweils eine rechteckige Struktur mit einer Schräge (151) aufweist.

13. Organische lichtemittierende Anzeigetafel (100) nach Anspruch 1, wobei sich ein Material jedes der Mehrzahl von Abschirmanschlüssen (150) von dem des mindestens einen Berührungsverbindungsstiftes (141) unterscheidet, wobei jeder der Mehrzahl von Abschirmanschlüssen (150) aus einem Schwarzmatrix-Material hergestellt ist.

14. Organische lichtemittierende Anzeigetafel (100) nach Anspruch 1, ferner mit einer anorganischen Schicht (190), die zwischen dem Glaskleber (130) und dem Substrat (120) angeordnet ist.

15. Organische lichtemittierende Anzeigetafel (100) nach Anspruch 1,
wobei eine Breite jedes Abschirmanschlusses (150), der zu mindestens einem Berührungsverbindungsstift (141) benachbart ist, gleich einer Breite des Berührungsverbindungsstiftes (141) ist;
wobei ein Abstand zwischen je zwei benachbarten Berührungsverbindungsstifte (141) gleich ist, ein Abstand zwischen je zwei benachbarten Abschirmanschlüssen (150) gleich ist und ein Abstand zwischen jeweils einem Berührungsverbindungsstift (141) und einem dazu benachbarten Abschirmanschluss (150) gleich ist, und
wobei sich die Breiten der Mehrzahl von Abschirmanschlüssen (150) entlang der Richtung, die sich vom mindestens einen Berührungsverbindungsstift (141) entfernt, jeweils um einen ersten voreingestellten Wert verringern und sich die Abstände zwischen je zwei benachbarten Abschirmanschlüssen (150) jeweils um einen zweiten voreingestellten Wert verringern; wobei der erste voreingestellte Wert und der zweite voreingestellte Wert jeweils 10 µm betragen;
wobei ein Material jedes der Mehrzahl von Abschirmanschlüssen (150) identisch mit dem von mindestens einem Berührungsverbindungsstift (141) ist und wobei eine Dicke jedes der Mehrzahl von Abschirmanschlüssen (150) gleich einer Dicke mindestens eines Berührungsverbindungsstiftes (141) ist.

16. Anzeigevorrichtung (10), die eine äußere Abdeckplatte (200) und eine organische lichtemittierende Anzeigetafel (100) nach Anspruch 1 aufweist,
wobei die äußere Abdeckplatte (200) auf einer Seite der lichtemittierenden Oberfläche der organischen lichtemittierenden Anzeigetafel (100) angeordnet ist.

17. Verfahren zum Versiegeln einer Anzeigetafel, das zum Versiegeln einer organischen lichtemittierenden Anzeigetafel (100) verwendet wird, wobei das Verfahren Folgendes umfasst:
Auftragen von Glaskleber (130) an einer Randposition zwischen der Abdeckplatte (110) und dem Substrat (120);
Durchführen eines Laser-Sinterns des Glasklebers (130) der Anzeigetafel entlang eines voreingestellten Pfades unter Verwendung einer Laservorrichtung;
als Reaktion darauf, dass erkannt wird, dass sich die Laservorrichtung in einen normalen Bereich (160) bewegt hat, Sintern des Glasklebers (130) im normalen Bereich (160) gemäß einer ersten voreingestellten Laserenergie und einer ersten voreingestellten Bewegungsgeschwindigkeit;
als Reaktion darauf, dass erkannt wird, dass sich die Laservorrichtung in einen Pufferbereich (170) bewegt hat, allmähliches Erhöhen der Laserenergie und/oder allmähliches Verringern der Bewegungsgeschwindigkeit, um den Glaskleber (130) im Pufferbereich (170) zu sintern; und
als Reaktion darauf, dass erkannt wird, dass sich die Laservorrichtung in einen Berührungsverbindungsstift-Bereich (180) bewegt hat, Erhöhen der Laserenergie, um den Glaskleber (130) im Berührungsverbindungsstift-Bereich (180) zu sintern;
wobei der Bereich, in dem die Berührungsverbindungsstifte (141) angeordnet sind, der Berührungsverbindungsstift-Bereich (180) ist,
der Bereich, in dem die Abschirmanschlüsse (150) vorgesehen sind, der Pufferbereich (170) ist, und
der Bereich ohne die Berührungsverbindungsstifte (141) und die Abschirmanschlüsse (150) der normale Bereich (160) ist;
wobei der mindestens eine Berührungsverbindungsstift (141) und die Mehrzahl von Abschirmanschlüssen (150), die beidseitig des mindestens einen Berührungsverbindungsstiftes (141) angeordnet sind, auf der Abdeckplatte (110) ausgebildet sind;
wobei der mindestens eine Berührungsverbindungsstift (141) und die Mehrzahl von Abschirmanschlüssen (150) an einer Position angeordnet sind, die dem Glaskleber (130) entspricht;
wobei eine Länge jedes der Mehrzahl von Abschirmanschlüssen (150) gleich einer Länge des mindestens einen Berührungsverbindungsstiftes (141) ist und wobei sich die Breiten der Mehrzahl von Abschirmanschlüssen (150) entlang einer Richtung, die sich vom mindestens einen Berührungsverbindungsstift (141) entfernt, allmählich verringern; und
wobei die Laser-Sinterverhältnisse des normalen Bereichs (160), des Pufferbereichs (170) und des Berührungsverbindungsstift-Bereichs (180) der Laservorrichtung gleich sind.

## Revendications

1. Panneau d'affichage électroluminescent organique (100) comprenant :
une plaque de recouvrement (110) ;
un substrat (120), agencé à l'opposé de la plaque de recouvrement (110) ;
une colle de verre (130) agencée au niveau d'une position de bord entre la plaque de recouvrement (110) et le substrat (120) ;
un circuit tactile (140) formé sur la plaque de recouvrement (110) ;
au moins une broche de liaison tactile (141), disposée au niveau d'un bord de la plaque de recouvrement (110) et couplée au circuit tactile (140) ; et
une pluralité de bornes de blindage (150), disposées des deux côtés de la au moins une broche de liaison tactile (141) ; dans lequel la au moins une broche de liaison tactile (141) et la pluralité de bornes de blindage (150) sont disposées au niveau d'une position correspondant à la colle de verre (130) ;
dans lequel une longueur de chacune de la pluralité de bornes de blindage (150) est égale à une longueur de la au moins une broche de liaison tactile (141), et dans lequel les largeurs de la pluralité de bornes de blindage (150) diminuent progressivement le long d'une direction s'éloignant de la au moins une broche de liaison tactile (141).

2. Panneau d'affichage électroluminescent organique (100) selon la revendication 1, dans lequel une largeur de chaque borne de blindage (150) adjacente à la au moins une broche de liaison tactile (141) est égale à une largeur de la au moins une broche de liaison tactile (141) ;
dans lequel un espacement entre chaque paire de broches de liaison tactiles adjacentes (141) est égal, un espacement entre chaque paire de bornes de blindage adjacentes (150) est égal, et un espacement entre chaque paire de broches de liaison tactiles (141) et de bornes de blindage (150) adjacentes mutuellement est égal, et dans lequel les largeurs de la pluralité de bornes de blindage (150) diminuent par décréments d'une première valeur prédéfinie dans la direction d'éloignement de la au moins une broche de liaison tactile (141).

3. Panneau d'affichage électroluminescent organique (100) selon la revendication 1, dans lequel une largeur de chaque borne de blindage (150) adjacente à la au moins une broche de liaison tactile (141) est égale à une largeur de la au moins une broche de liaison tactile (141) ; dans lequel, dans la direction d'éloignement de la au moins une broche de liaison tactile (141), les largeurs de la pluralité de bornes de blindage (150) diminuent par décréments d'une première valeur prédéfinie, et les distances entre chaque paire de bornes de blindage adjacentes (150) diminuent par décréments d'une seconde valeur prédéfinie, dans lequel la première valeur prédéfinie est égale à la seconde valeur prédéfinie.

4. Panneau d'affichage électroluminescent organique (100) selon la revendication 1, dans lequel une largeur de chaque borne de blindage (150) adjacente à la au moins une broche de liaison tactile (141) est égale à une largeur de la au moins une broche de liaison tactile (141) ;
dans lequel, dans la direction d'éloignement de la au moins une broche de liaison tactile (141), les largeurs de la pluralité de bornes de blindage (150) diminuent par décréments d'une première valeur prédéfinie, et les distances entre chaque paire de bornes de blindage adjacentes (150) augmentent par incréments d'une seconde valeur prédéfinie, dans lequel la première valeur prédéfinie est égale à la seconde valeur prédéfinie.

5. Panneau d'affichage électroluminescent organique (100) selon l'une quelconque des revendications 3 à 4, dans lequel la première valeur prédéfinie et la seconde valeur prédéfinie sont chacune de 10 µm.

6. Panneau d'affichage électroluminescent organique (100) selon la revendication 1, dans lequel le matériau de chacune de la pluralité de bornes de blindage (150) est le même que celui de la au moins une broche de liaison tactile (141), et dans lequel une épaisseur de chacune de la pluralité de bornes de blindage (150) est égale à une épaisseur de la au moins une broche de liaison tactile (141).

7. Panneau d'affichage électroluminescent organique (100) selon la revendication 6, dans lequel de chaque borne de blindage (150) adjacente à la au moins une broche de liaison tactile (141), un côté adjacent à la broche de liaison tactile respective (141) est une pente (151), qui est supérieure ou égale à 45° et inférieure à 90° ;
dans lequel la borne de blindage (150) est réalisée en un matériau métallique.

8. Panneau d'affichage électroluminescent organique (100) selon la revendication 1, dans lequel, de chaque borne de blindage (150) adjacente à la au moins une broche de liaison tactile (141), un côté adjacent à la broche de liaison tactile respective (141) est une pente (151), qui est supérieure ou égale à 45° et inférieure à 90°, dans lequel la pluralité de bornes de blindage (150) est chacune réalisée en un matériau de filtre de couleur, et dans lequel, dans chaque borne de blindage (150) adjacente à la au moins une broche de liaison tactile (141), une transmittance lumineuse diminue progressivement le long d'une direction d'inclinaison de la pente (151).

9. Panneau d'affichage électroluminescent organique (100) selon la revendication 7, dans lequel un matériau réfléchissant est disposé sur la pente (151).

10. Panneau d'affichage électroluminescent organique (100) selon la revendication 1, dans lequel une épaisseur de chacune de la pluralité de bornes de blindage (150) est supérieure à une épaisseur de la au moins une broche de liaison tactile (141).

11. Panneau d'affichage électroluminescent organique (100) selon la revendication 7, dans lequel la pente (151) est en forme d'arc, et dans lequel la surface en forme d'arc fait face à la broche de liaison tactile (141).

12. Panneau d'affichage électroluminescent organique (100) selon la revendication 7, dans lequel la pluralité de bornes de blindage (150) est chacune une structure rectangulaire présentant une pente (151).

13. Panneau d'affichage électroluminescent organique (100) selon la revendication 1, dans lequel un matériau de chacune de la pluralité de bornes de blindage (150) est différent de celui de la au moins une broche de liaison tactile (141), dans lequel chacune de la pluralité de bornes de blindage (150) est réalisée en un matériau de matrice noire.

14. Panneau d'affichage électroluminescent organique (100) selon la revendication 1, comprenant en outre une couche inorganique (190) disposée entre la colle de verre (130) et le substrat (120).

15. Panneau d'affichage électroluminescent organique (100) selon la revendication 1,
dans lequel une largeur de chaque borne de blindage (150) adjacente à la au moins une broche de liaison tactile (141) est égale à une largeur de la au moins une broche de liaison tactile (141) ; dans lequel un espacement entre chaque paire de broches de liaison tactiles adjacentes (141) est égal, un espacement entre chaque paire de bornes de blindage adjacentes (150) est égal, et un espacement entre chaque paire de broches de liaison tactiles (141) et de bornes de blindage (150) adjacentes mutuellement est égal, et dans lequel les largeurs de la pluralité de bornes de blindage (150) diminuent par décréments d'une première valeur prédéfinie dans la direction d'éloignement de la au moins une broche de liaison tactile (141) et des distances entre chaque paire de bornes de blindage (150) diminuent par décréments d'une seconde valeur prédéfinie ;
dans lequel la première valeur prédéfinie et la seconde valeur prédéfinie sont chacune de 10 µm ;
dans lequel le matériau de chacune de la pluralité de bornes de blindage (150) est identique à celui de la au moins une broche de liaison tactile (141), et dans lequel une épaisseur de chacune de la pluralité de bornes de blindage (150) est égale à une épaisseur de la au moins une broche de liaison tactile (141).

16. Dispositif d'affichage (10), comprenant une plaque de recouvrement extérieure (200) et un panneau d'affichage électroluminescent organique (100) selon la revendication 1, dans lequel la plaque de recouvrement extérieure (200) est agencée sur un côté d'une surface électroluminescente du panneau d'affichage électroluminescent organique (100).

17. Procédé de scellage d'un panneau d'affichage, utilisé pour sceller un panneau d'affichage électroluminescent organique (100), le procédé comprenant :
le revêtement d'une colle de verre (130) au niveau de la position de bord entre la plaque de recouvrement (110) et le substrat (120) ;
la réalisation d'un frittage laser sur la colle de verre (130) du panneau d'affichage le long d'un trajet prédéfini à l'aide d'un équipement laser ;
en réponse à la détection que le dispositif laser s'est déplacé vers une région normale (160), le frittage de la colle de verre (130) dans la région normale (160) selon une première énergie laser prédéfinie et une première vitesse de déplacement prédéfinie ;
en réponse à la détection que le dispositif laser s'est déplacé dans une région tampon (170), l'augmentation progressive de l'énergie de laser et/ou la réduction progressive de la vitesse de déplacement pour fritter la colle de verre (130) dans la région tampon (170) ; et
en réponse à la détection que le dispositif laser s'est déplacé vers une région de broche de liaison tactile (180), l'augmentation de l'énergie laser pour fritter la colle de verre (130) dans la région de broche de liaison tactile (180) ;
dans lequel la région où sont disposées les broches de liaison tactile (141) est la région de broche de liaison tactile (180),
la région munie des bornes de blindage (150) est la région tampon (170), et
la région sans broches de liaison tactile (141) et sans bornes de blindage (150) est la région normale (160) ;
dans lequel la au moins une broche de liaison tactile (141) et la pluralité de bornes de blindage (150) situées des deux côtés de la au moins une broche de liaison tactile (141) sont formées sur la plaque de recouvrement (110) ;
dans lequel la au moins une broche de liaison tactile (141) et la pluralité de bornes de blindage (150) sont disposées à une position correspondant à la colle de verre (130) ; dans lequel la longueur de chacune de la pluralité de bornes de blindage (150) est égale à la longueur de la au moins une broche de liaison tactile (141), et dans lequel les largeurs de la pluralité de bornes de blindage (150) diminuent progressivement dans une direction d'éloignement de la au moins une broche de liaison tactile (141) ; et
dans lequel les rapports de frittage laser de la région normale (160), de la région tampon (170) et de la région de broche de liaison tactile (180) de l'équipement laser sont égaux.
